# EUROPEAN PATENT APPLICATION

(11) **EP 1 548 707 A2**
(43) Date of publication of application: **29.06.2005**
(21) Application number: 04030268.9
(22) Date of filing: 21.12.2004
(51) Int. Cl.: G10L 21/02

(54) **Noise eliminating apparatus and receiver**

(30) Priority: 26.12.2003 JP 2003435491
(71) Applicant: Pioneer Corporation, Tokyo-to (JP)
(72) Inventor: Ohashi, Toru, Yamada Kawagoe-shi Saitama-ken (JP)
(74) Representative: Klingseisen, Franz

(57) **Abstract**

A noise detector (31) extracts pulse noise. On the basis of the extracted pulse noise, a threshold generator (32) generates a threshold. A gate pulse generator (33) compares the pulse noise with the threshold and, when the waveform of the pulse noise exceeds the threshold, generates a gate pulse. During the gate pulse is generated, a gate (34) inhibits outputting of a demodulated signal of a detector (26), and during the period, interpolates the signal to output the resultant, thereby eliminating pulse noise from an output signal of the gate (34).

## Description

### BACKGROUND OF THE INVENTION

### 1.Field of the Invention

The present invention relates to a noise eliminating apparatus and a receiver having the same. The use of the invention is not limited to the receiver and a diversity receiving method.

### 2.Description of the Related Art

Hitherto, a sound processing apparatus having the function of eliminating noise in a sound signal is known (refer to, for example, Japanese Patent Application Laid-open No. 7-177597). The disclosure of the corresponding US5568559A is incorporated by reference in its entirety. In the apparatus disclosed in this patent document, low frequency components in a digital sound signal are extracted by a low pass filter (hereinbelow, abbreviated as LPF). Anecessary frequency area of a sound signal is extracted by a band pass filter (hereinbelow, abbreviated as BPF). An output of the LPF and an output of the BPF are compared with each other to thereby detect an amount of wind noise. On the basis of the result of detection, the low frequency component extracted by the LPF is multiplied with a coefficient. By subtracting the result of multiplication from the original sound signal, the wind noise is properly eliminated from the sound signal in accordance with the level.

### SUMMARY OF THE INVENTION

In the case of the conventional technique, the noise of the low frequency component included in the sound signal is extracted and subtracted from the original sound signal. Consequently, there is a problem such that the conventional technique is not adapted to eliminate pulse noise. One object of the invention is to solve the problem.

The invention according to claim 1 relates to a noise eliminating apparatus comprising:
a noise detector which detects pulse noise included in a signal to be processed;
a threshold generator which generates a threshold on the basis of the pulse noise detected by said noise detector;
a gate pulse generator which compares the pulse noise detected by said noise detector with the threshold generated by said threshold generator and, when the level of said pulse noise exceeds said threshold, generates a gate pulse; and
a gate which inhibits outputting of said signal to be processed during the period in which said gate pulse is output from said gate pulse generator, and interpolates a signal in the period of inhibition to output the resultant signal.

The invention according to claim 5 relates to a receiver comprising:
a noise detector which detects pulse noise included in a signal to be processed;
a threshold generator which generates a threshold on the basis of the pulse noise detected by said noise detector;
a gate pulse generator which compares the pulse noise detected by said noise detector with the threshold generated by said threshold generator and, when the level of said pulse noise exceeds said threshold, generates a gate pulse;
a gate which inhibits outputting of said signal to be processed during the period in which said gate pulse is output from said gate pulse generator and interpolates a signal in the period of inhibition to output the resultant signal;
a frequency converter which converts a modulated reception signal into an intermediate frequency signal;
an intermediate frequency filter which passes a desired frequency area of an intermediate frequency signal output from said frequency converter; and
a detector which demodulates a signal that has passed through said intermediate frequency filter,
wherein said noise detector detects pulse noise included in an intermediate frequency signal output from said frequency converter as pulse noise included in a signal to be processed, and
said gate inhibits outputting of the signal demodulated by said detector during a period in which a gate pulse is output from said gate pulse generator and interpolates the signal in the inhibition period to output the resultant signal.

### BRIEF DESCRIPTION OF THE DRAWINGS

FIG. 1 is a block diagram showing the configuration of a noise eliminating apparatus and a receiver in a first embodiment;
FIG. 2 is a block diagram showing the configuration of a main portion of the noise eliminating apparatus in the first embodiment;
FIG. 3 is a waveform chart illustrating operation of the first embodiment;
FIG. 4 is a waveform chart illustrating operation of the first embodiment;
FIG. 5 is a block diagram showing the configuration of a main portion of a noise eliminating apparatus in a second embodiment;
FIG. 6 is a circuit diagram conceptually showing the configuration of the main portion of the noise eliminating apparatus in the second embodiment;
FIG. 7 is a waveform chart illustrating operation of the second embodiment;
FIG. 8 is a waveform chart illustrating operation of the second embodiment; and
FIG. 9 is a waveform chart illustrating operation of the second embodiment.

### DESCRIPTION OF THE PREFERRED EMBODIMENTS

Preferred embodiments of a noise eliminating apparatus according to the invention and a receiver having the noise eliminating apparatus will be described in detail hereinbelow with reference to the appended drawings.

### (First Embodiment)

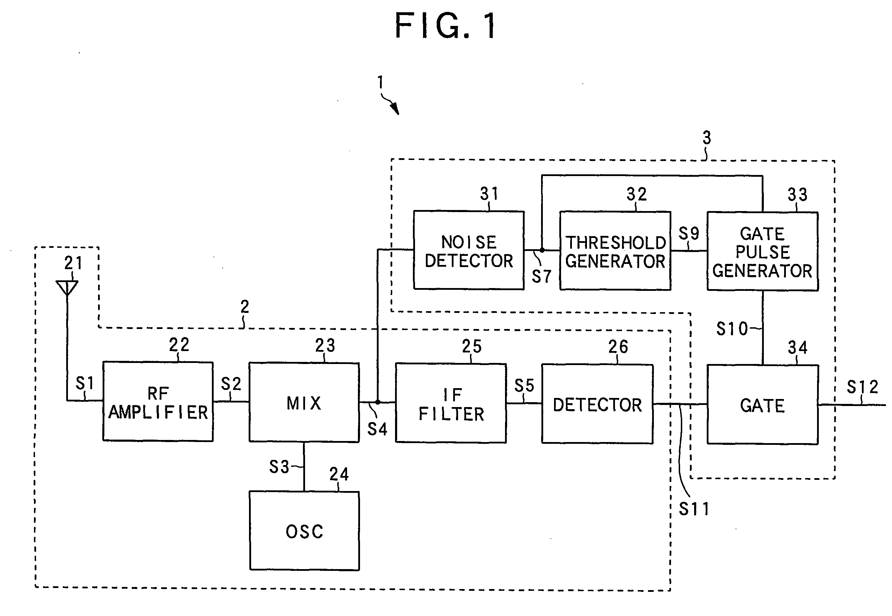

FIG. 1 is a block diagram showing the configuration of a noise eliminating apparatus and a receiver of a first embodiment. As shown in FIG. 1, a receiver 1 comprises:
a receiving device 2 including an antenna 21, a high frequency amplifier (RF amplifier) 22, a frequency mixer (MIX) 23, a local oscillator (OSC) 24, an intermediate frequency filter (IF filter) 25, and a detector 26; and a noise eliminating apparatus 3 including a noise detector 31, a threshold generator 32, a gate pulse generator 33, and a gate 34.

As the receiving device 2, a general super heterodyne receiver is used. An electromagnetic wave is received from the space by the receiver 1 via the antenna 21. The RF amplifier 22 amplifies a high-frequency reception signal S1 received by the receiver 1 via the antenna 21. The frequency mixer 23 mixes a high-frequency signal S2 amplified by the RF amplifier 22 with an oscillation signal S3 of the local oscillator 24, and converts the frequency difference between the signals S2 and S3 into an intermediate frequency.

The local oscillator 24 outputs the oscillation signal S3 used for frequency conversion. The frequency mixer 23 and local oscillator 24 have the function of frequency converting device. The intermediate frequency filter 25 is a narrow-band filter and eliminates adjacent signals from an intermediate frequency signal S4 obtained by the frequency converting device. The detector 26 demodulates a signal S5 passed through the intermediate frequency filter 25.

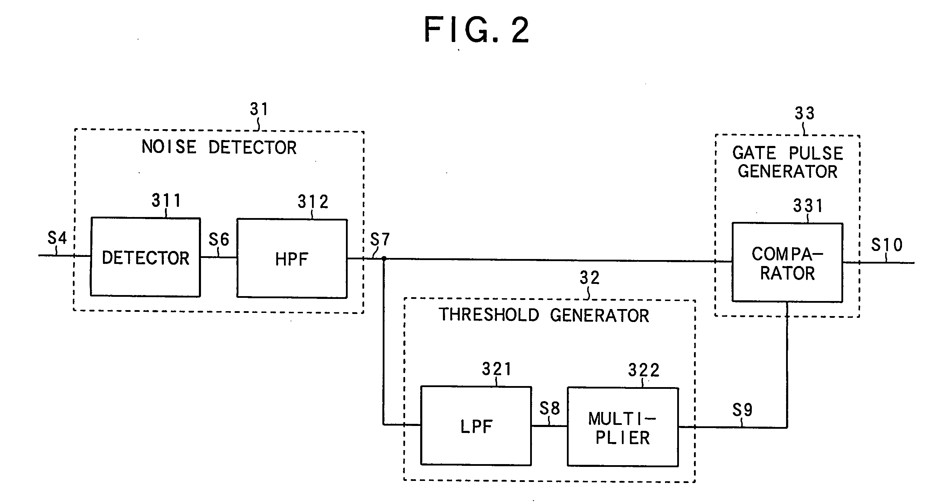

FIG. 2 is a block diagram showing the configuration of the noise detector 31, threshold generator 32, and gate pulse generator 33. As shown in FIG. 2, the noise detector 31 comprises a detector 311 and a high pass filter (hereinbelow, abbreviated as HPF) 312. The detector 311 demodulates the intermediate frequency signal S4 obtained by the frequency converting device. The HPF 312 filters an output signal S6 of the detector 311 so as to pass high frequency components, thereby extracting pulse noise.

The threshold generator 32 comprises, as shown in FIG. 2, an LPF 321 and a multiplier 322. A signal (pulse noise) S7 passed through the HPF 312 is supplied to the multiplier 322 via the LPF 321. The multiplier 322 multiplies an output signal S8 of the LPF 321 by "n" and outputs the resultant as a threshold. As themagnification "n" of the multiplier 322, a value adapted to perform the noise process is selected. When pulse noise continuously enters the threshold generator 32, the LPF 321 operates as an integrator, so that an output of the LPF 321 increases. With this increase, the threshold increases. That is, the LPF 321 has the function of threshold adjusting device for increasing the threshold in accordance with input of continuous pulse noise.

The gate pulse generator 33 comprises, as shown in FIG. 2, a comparator 331. The comparator 331 generates a gate pulse S10 on the basis of the output signal (pulse noise) S7 of the noise detector 31 and an output signal (threshold) S9 of the threshold generator 32. When the gate pulse S10 is not generated, the gate 34 outputs a demodulated signal S11 obtained by the detector 26 as an output signal S12. On the other hand, while the gate pulse S10 is generated, the gate 34 inhibits outputting of the demodulated signal S11 obtained by the detector 26 and, instead, outputs the output signal S12 interpolated by any of various interpolating methods such as linear interpolation.

The operation of the first embodiment will now be described. Electromagnetic waves such as AM broadcast wave are induced by the antenna 21 and received by the receiver 1. The high-frequency reception signal S1 received by the receiver 1 is amplified by the RF amplifier 22 and becomes the intermediate frequency signal S4 via the frequency mixer 23. The intermediate frequency signal S4 is detected by the detector 26 via the narrow-band intermediate frequency filter 25 in the receiving unit 2 and becomes the demodulated signal S11. The demodulated signal S11 is supplied to the gate 34.

The intermediate frequency signal S4 output from the frequency mixer 23 is, on the other hand, directly detected by the detector 311 without passing through a narrow-band intermediate frequency filter in the noise eliminating apparatus 3. Therefore, the demodulated signal S6 obtained by detection in the detector 311 includes pulse noise of a large amplitude. By passing the demodulated signal S6 via the HPF 312, the pulse noise S7 is extracted. The extracted pulse noise S7 passes through the LPF 321 and is multiplied by "n" by the multiplier 322.

An output of the multiplier 322 is supplied as the threshold S9 to the comparator 331. The pulse noise S7 output from the HPF 312 is also supplied to the comparator 331. The comparator 331 compares the pulse noise S7 supplied from the noise detector 31 with the threshold S9 supplied from the threshold generator 32. As a result of comparison, when the level of the pulse noise S7 exceeds the threshold S9, the gate pulse S10 is generated. The generated gate pulse S10 is supplied to the gate 34. When the peak value of the pulse noise S7 decreases and becomes equal to or lower than the threshold S9, the gate pulse S10 is not output.

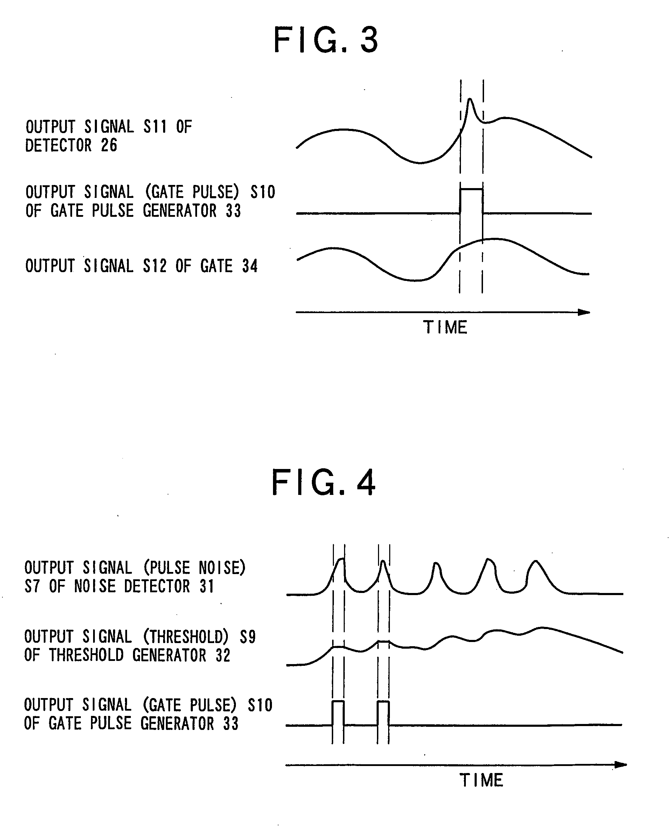

FIG. 3 is a waveform chart showing waveforms of the demodulated signal S11 of the detector 26, the output signal (gate pulse) S10 of the gate pulse generator 33, and the output signal S12 of the gate 34. As shown in FIG. 3, the gate 34 inhibits outputting the demodulated signal S11 of the detector 26 during the period in which the gate pulse S10 is supplied. During the period of inhibition, the gate 34 interpolates the output signal 12 by any of the various interpolating methods to output the interpolated signal. By the operation, as shown in FIG. 3, although the pulse noise exceeding the threshold S9 is included in the demodulated signal S11 of the detector 26, the output signal S12 having the waveform from which the pulse noise is eliminated is obtained.

FIG. 4 is a waveform chart showing waveforms of the output signal (pulse noise) S7 of the noise detector 31, the output signal (threshold) S9 of the threshold generator 32, and the output signal (gate pulse) S10 of the gate pulse generator 33 in the case where pulse noise continues. As shown in FIG. 4, when the pulse noise continues, the threshold S9 gradually increases. This is because the LPF 321 operates as an integrator as described above. When the threshold S9 is lower than the level of the pulse noise S7, each time the pulse noise S7 enters, the gate pulse S10 is generated.

When the threshold S9 increases and becomes equal to or higher than the level of the pulse noise S7, even if the pulse noise S7 enters, the gate pulse S10 is not generated. Therefore, when the pulse noise enters continuously, although the output signal S12 from which noise is eliminated by interpolation is output from the gate 34 initially, and after lapse of some time, the demodulated signal S11 of the detector 26 is output as the output signal S12 from the gate 34. By such operation, at the time of continuous noise, the gate 34 continuously operates to thereby prevent the output signal such as the sound signal from being interrupted.

As described above, in the first embodiment, the threshold generator 32 generates the threshold S9 on the basis of the pulse noise S7 detected by the noise detector 31. When the pulse noise S7 exceeds the threshold S9, the gate 34 inhibits outputting of the demodulated signal S11 of the detector 26 by the gate pulse S10 generated by the gate pulse generator 33 and interpolates signals during the period. Thus, pulse noise can be eliminated.

### (Second Embodiment)

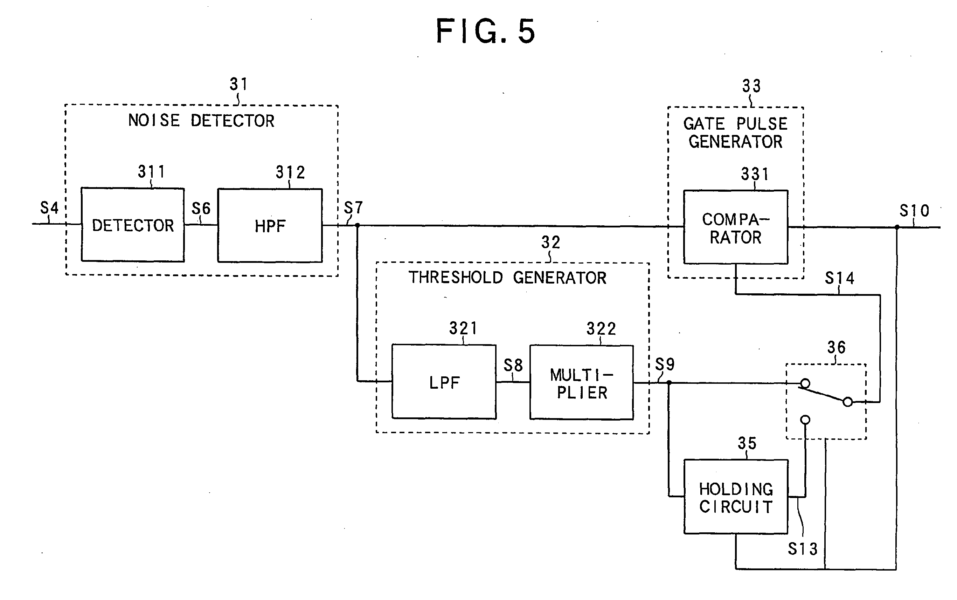

FIG. 5 is a block diagram showing the configuration of a main portion of a noise eliminating apparatus of a second embodiment. As shown in FIG. 5, the second embodiment is similar to the first embodiment except that a holding circuit 35 and a switch 36 are provided between the threshold generator 32 and the gate pulse generator 33. The holding circuit 35 retains the threshold S9 output from the threshold generator 32. The switch 36 switches between the threshold S9 output from the threshold generator 32 and a threshold S13 held in the holding circuit 35 and supplies the selected threshold to the gate pulse generator 33. The other configuration is the same as that of the first embodiment. The same reference numerals are designated to the same components as those of the first embodiment and their description will not be repeated.

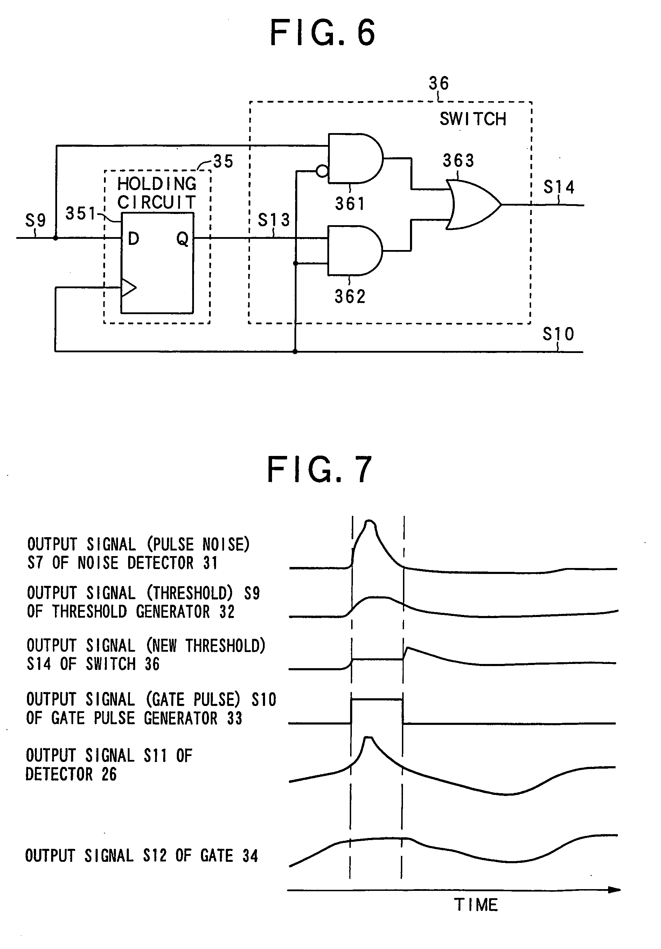

FIG. 6 is a circuit diagram conceptually showing the configuration of the holding circuit 35 and the switch 36. As shown in FIG. 6, the holding circuit 35 comprises a D flip flop 351. To a data terminal D of the D flip flop 351, the threshold S9 output from the threshold generator 32 is supplied. By using the rising edge of the gate pulse S10 as a trigger, the D flip flop 351 latches the threshold supplied to the data terminal D at the time. The D flip flop 351 holds the latched threshold and continuously outputs it from an output terminal Q until the next rising edge of the gate pulse S10 is input.

As shown in FIG. 6, the switch 36 comprises two AND gates 361 and 362 and an OR gate 363. The first AND gate 361 outputs the threshold S9 output from the threshold generator 32 to the OR gate 363 in the period after the gate pulse S10 becomes the high level until the gate pulse S10 becomes the high level again. The second AND gate 362 outputs the threshold S13 output from the holding circuit 35 to the OR gate 363 in the period after the gate pulse S10 becomes the high level until the gate pulse S10 becomes the low level.

The OR gate 363 supplies, as a new threshold S14, either the threshold S9 supplied from the first AND gate 361 or the threshold S13 supplied from the second AND gate 362 to the comparator 331 of the gate pulse generator 33. The comparator 331 outputs the gate pulse S10 on the basis of the threshold S14 supplied from the OR gate 363.

The operation of the second embodiment will now be described. Since the operations of the receiving device 2, noise detector 31, threshold generator 32, and gate 34 are the same as those of the first embodiment, their description will not be repeated. FIG. 7 is a waveform chart showing waveforms of the output signal (pulse noise) S7 of the noise detector 31, output signal (threshold) S9 of the threshold generator 32, output signal (new threshold) S14 of the switch 36, output signal (gate pulse) S10 of the gate pulse generator 33, demodulated signal S11 of the detector 26, and output signal S12 of the gate 34.

In a normal state where there is no pulse noise, the gate pulse S10 is not output from the gate pulse generator 33. Therefore, the threshold S9 output fromthemultiplier 322 of the threshold generator 32 is supplied as it is from the switch 36 to the comparator 331 via the first AND gate 361 and OR gate 363. At this time, there is no output from the second AND gate 362 to the OR gate 363.

When the pulse noise S7 exceeding the threshold S9 enters the comparator 331, the gate pulse S10 is output from the comparator 331. Synchronously with the rising edge of the gate pulse S10, the D flip flop 351 latches the threshold S9 output from the multiplier 322. The D flip flop 351 then continuously outputs the latched threshold S13 to the second AND gate 362.

The second AND gate 362 outputs the threshold S13 supplied from the D flip flop 351 to the OR gate 363 until the gate pulse S10 becomes the low level again. At this time, there is no output from the first AND gate 361 to the OR gate 363. Therefore, in the period after the gate pulse S10 becomes the high level until the gate pulse S10 becomes the low level, the OR gate 363 supplies the threshold S9 at the moment when the gate pulse S10 becomes the high level, the threshold S9 being the new threshold S14 to the comparator 331.

Specifically, in the period after the gate pulse S10 becomes the high level and until the gate pulse S10 becomes the low level, as described in the first embodiment, the threshold S9 output from the threshold generator 32 increases with lapse of time. To the comparator 331, however, the new threshold S14 as a constant value is supplied. When the peak value of the pulse noise S7 decreases and becomes equal to or lower than the new threshold S14, the gate pulse S10 is not output. By such operation, the gate pulse S10 is output from the comparator 331 until the peak value of the pulse noise S7 sufficiently decreases.

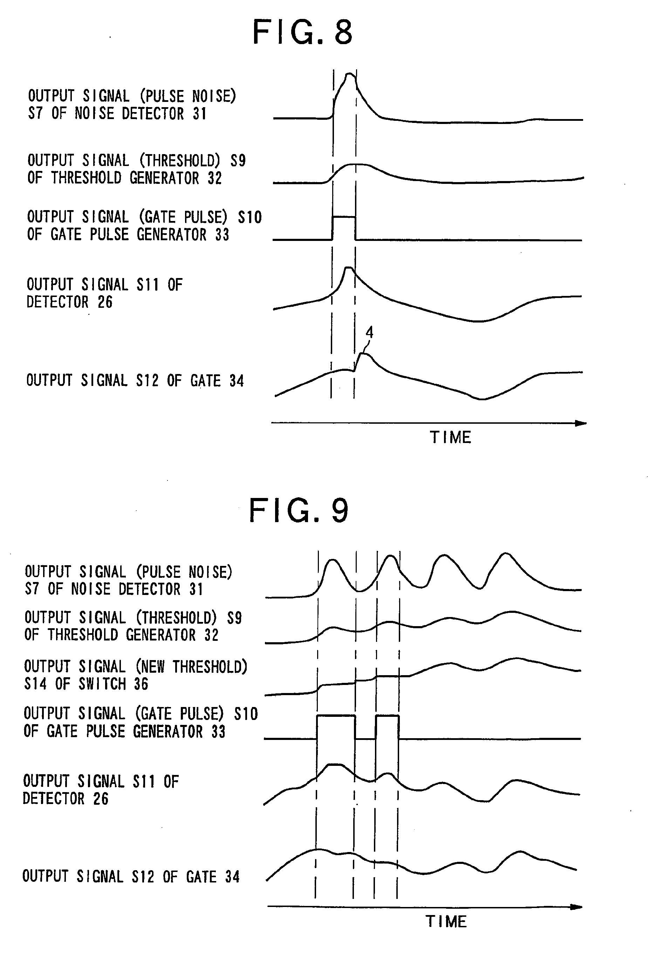

Therefore, a situation can be prevented such that time to generate the gate pulse S10 is shortened due to increase in the threshold S9 and noise remains in the output signal S12 of the gate 34. In the case where the holding circuit 35 and switch 36 are not provided, as shown in FIG. 8, the threshold S9 becomes high level during the time when the pulse noise S7 enters. Consequently, time to generate the gate pulse S10 becomes shorter than time in which the pulse noise S7 occurs, so that part of the noise may remain in the output signal S12 of the gate 34 as shown by reference numeral 4 in FIG. 8.

FIG. 9 is a waveform chart showing waveforms of the output signal (pulse noise) S7 of the noise detector 31, output signal (threshold) S9 of the threshold generator 32, output signal (new threshold) S14 of the switch 36, output signal (gate pulse) S10 of the gate pulse generator 33, demodulated signal S11 of the detector 26, and output signal S12 of the gate 34 in the case where pulse noise continues. As shown in FIG. 9, when the threshold S9 is lower than the level of the pulse noise S7, the gate pulse S10 is generated each time the pulse noise S7 enters.

When pulse noise continues, in a manner similar to the first embodiment, the threshold S9 gradually increases. With this icrease, the output signal (new threshold) S14 of the switch 36 also gradually increases. However, while the gate pulse S10 is generated, the new threshold S14 is constant. When the threshold S9 increases and becomes equal to or higher than the level of the pulse noise S7, even if the pulse noise S7 enters, the gate pulse S10 is not generated. By such operation, the gate 34 continuously operates at the time of continuous noise, and a situation can be prevented such that the output signal such as sound signal is interrupted.

As described above, in the noise eliminating apparatus of the second embodiment, when the gate pulse S10 is generated due to entry of the pulse noise S7, the threshold S9 at the moment when the gate pulse S10 is generated is held by the holding circuit 35. While the gate pulse S10 is generated by the switching of the switch 36, the threshold S13 held by the holding circuit 35 is used as the new threshold S14, so that precision of time to generate the gate pulse S10 improves largely. Therefore, part of the noise can be prevented from remaining.

In the foregoing embodiments, the receiver 1 is described as a receiver used for AM broadcast. However, the receiver 1 of the embodiment is not limited to AM broadcast but can be used as a receiver for FM broadcast, television broadcast or other radio receivers. The receiving method of the receiver 1 of the embodiment is not limited to the super heterodyne method. The noise eliminating apparatus 3 of the embodiment is not limited to a radio receiver but can be used to eliminate pulse noise in an apparatus that performs various signal processes.

The invention may be embodied in other specific forms without departing from the spirit thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein.

## Claims

1. A noise eliminating apparatus, **characterized in that** it comprises:
a noise detector (31) which detects pulse noise included in a signal to be processed;
a threshold generator (32) which generates a threshold on the basis of the pulse noise detected by said noise detector (31);
a gate pulse generator (33) which compares the pulse noise detected by said noise detector (31) with the threshold generated by said threshold generator (32) and, when the level of said pulse noise exceeds said threshold, generates a gate pulse; and
a gate (34) which inhibits outputting of said signal to be processed during the period in which said gate pulse is output from said gate pulse generator (33), and interpolates a signal in the period of inhibition to output the resultant signal.

2. The noise eliminating apparatus according to claim 1, wherein said threshold generator (32) further comprises a threshold adjusting device which increases a threshold in response to entry of continuous pulse noise.

3. The noise eliminating apparatus according to claim 2, wherein said threshold adjusting device includes a low pass filter.

4. The noise eliminating apparatus according to claim 2, further comprising:
a holding circuit (35) which holds a threshold output from said threshold generator (32) synchronously with generation of said gate pulse; and
a switch (36) which selects the threshold held in said holding circuit (35) during a period in which said gate pulse is generated, to select the threshold output from said threshold generator (32) during a period in which said gate pulse is not generated, as the threshold being a threshold to be compared with the pulse noise detected by said noise detector (31) in said gate pulse generator (33).

5. A receiver, **characterized in that** it comprises:
a noise detector (31) which detects pulse noise included in a signal to be processed;
a threshold generator (32) which generates a threshold on the basis of the pulse noise detected by said noise detector (31);
a gate pulse generator (33) which compares the pulse noise detected by said noise detector (31) with the threshold generated by said threshold generator (32) and, when the level of said pulse noise exceeds said threshold, generates a gate pulse;
a gate (34) which inhibits outputting of said signal to be processed during the period in which said gate pulse is output from said gate pulse generator (33) and interpolates a signal in the period of inhibition to output the resultant signal;
a frequency converter (23,24) which converts a modulated reception signal into an intermediate frequency signal;
an intermediate frequency filter (25) which passes a desired frequency area of an intermediate frequency signal output from said frequency converter (23, 24) ; and
a detector (26) which demodulates a signal that has passed through said intermediate frequency filter (25),
wherein said noise detector (31) detects pulse noise included in an intermediate frequency signal output from said frequency converter (23,24) as pulse noise included in a signal to be processed, and
said gate (34) inhibits outputting of the signal demodulated by said detector (26) during a period in which a gate pulse is output from said gate pulse generator (33) and interpolates the signal in the inhibition period to output the resultant signal.

6. The receiver according to claim 5, wherein said threshold generator (32) further comprises a threshold adjusting device which increases a threshold in response to continuous pulse noise.
